# FASCICULE DE BREVET EUROPEEN

(11) **EP 1 949 409 B1**
(45) Date de publication et mention de la délivrance du brevet: **14.12.2011**
(21) Numéro de dépôt: 06831028.3
(22) Date de dépôt: 26.10.2006
(51) Int. Cl.: H01J 37/34

(54) **PROCEDE ET INSTALLATION D'AVIVAGE SOUS VIDE PAR PULVERISATION MAGNETRON D'UNE BANDE METALLIQUE**
VERFAHREN UND INSTALLATION ZUR UNTERDRUCKFÄRBUNG EINES METALLSTREIFENS MITTELS MAGNETRON-SPUTTERN
METHOD AND INSTALLATION FOR THE VACUUM COLOURING OF A METAL STRIP BY MEANS OF MAGNETRON SPUTTERING

(30) Priorité: 07.11.2005 EP 05292355
(43) Date de publication de la demande: 30.07.2008
(73) Titulaire: ArcelorMittal France, 93200 Saint-Denis (FR)
(72) Inventeur: CORNIL, Hugues, B-4570 Marchin (BE); DEWEER, Benoît, B-1933 Sterrebeek (BE); MABOGE, Claude, B-5650 Castillon (BE)
(74) Mandataire: Plaisant, Sophie Marie
(86) Numéro de dépôt international: PCT/FR2006/002415
(87) Numéro de publication internationale: WO 2007/051917

(56) Documents cités:
- EP-A- 0 535 568
- EP-A- 0 878 565
- WO-A-2004/101844
- US-A1- 2004 060 131
- DATABASE EPODOC EUROPEAN PATENT OFFICE, THE HAGUE, NL; TW531466B 11 mai 2003 (2003-05-11), MOSEL VITELIC INC: "Mechanical polishing apparatus and method of cleaning a lower electrode of a plasma" XP002381727 & TW 531 466 B (MOSEL VITELIC INC) 11 mai 2003 (2003-05-11)

## Description

La présente invention concerne un procédé et une installation d'avivage sous vide par pulvérisation magnétron d'une bande métallique, telle qu'une bande d'acier, par exemple.

Lors des opérations de revêtement sous vide d'une bande d'acier, l'état de propreté de la bande avant dépôt est l'un des facteurs clés de réussite, car il détermine la bonne adhérence du revêtement à déposer. Un des procédés utilisés pour ce faire est l'avivage sous vide par pulvérisation magnétron encore appelé etching. Ce procédé consiste à créer un plasma entre la bande et une contre-électrode, dans un gaz permettant de générer des radicaux et/ou ions. Ces ions vont, dans les conditions normales de fonctionnement, être accélérés vers la surface de la bande à décaper, et venir arracher des atomes superficiels, nettoyant ainsi la surface éventuellement souillée, tout en l'activant.

La bande à décaper se déplace dans une chambre sous vide en regard d'une contre-électrode. Cette dernière est polarisée positivement par rapport à la bande métallique, elle-même préférentiellement reliée à la masse. Un ensemble d'aimants positionné à l'arrière de la bande confine le plasma créé auprès de celle-ci. Afin de positionner de façon très précise la bande métallique à traiter, par rapport à la contre-électrode nécessaire à la mise en oeuvre de la pulvérisation magnétron, la bande métallique est généralement disposée sur un rouleau d'appui qui peut être mis en rotation autour de son axe. Ce type de rouleau n'est cependant pas nécessaire lorsque l'on traite des bandes métalliques en forme de plaques rigides.

Le problème qui se pose cependant lors de l'application de cette technique pour le nettoyage d'une bande métallique telle qu'une bande d'acier en défilement continu est l'encrassement de la contre-électrode. Lors du procédé d'avivage, les particules érodées de la surface de la bande se déposent sur les parties en vis à vis, c'est à dire sur la contre-électrode, et la couvrent avec le temps d'un film noir peu adhérent. Celui-ci finit par se craqueler et peler en formant des copeaux pulvérulents initiateurs d'arcs. La formation d'arcs peut provoquer :
- d'une part un endommagement de la surface de la bande d'acier à l'endroit où l'arc est initié,
- d'autre part un défaut d'avivage sur une petite surface de la bande en défilement de par la suspension de courte durée (100 µs environ) de l'alimentation en courant par le générateur lors de la détection de l'arc.

Enfin, lorsqu'il est diélectrique, le dépôt peut isoler l'électrode et gêner le fonctionnement du plasma.

Le maintien d'un bon état de propreté de la contre électrode lors du procédé d'avivage s'avère donc indispensable.

On connaît le document EP-A-0 908 535 qui décrit un procédé de décapage de la surface d'une bande métallique contaminée par une couche mince d'oxyde. Les contre-électrodes mises en oeuvre sont utilisées par paires reliées à un générateur de courant alternatif. Elles ont une forme plate ou arrondie et permettent d'éviter la formation d'arcs pendant un certain temps. Au bout d'une certaine durée de mise en service, ces électrodes s'encrassent, ce qui oblige à interrompre le procédé pour les nettoyer ou bien à diminuer la puissance de l'avivage, ce qui nuit de toutes les façons à son efficacité et/ou à sa qualité,

Le document EP878565 décrit un procédé de décapage d'une bande métallique défilant entre une électrode et un circuit magnétique.

Le document WO 2004/101844 décrit une électrode rotative et un dispositif de nettoyage de la surface de l'électrode.

La présente invention a donc pour but de remédier aux inconvénients de procédés de l'art antérieur en mettant à disposition un procédé et une installation d'avivage sous vide par sputtering magnétron de la surface d'une bande métallique en défilement, qui permette d'améliorer la qualité et l'efficacité de l'avivage en évitant tout endommagement de la bande métallique et tout défaut d'avivage dus à la formation intempestive d'arcs électriques, et ce, sans interruption du procédé.

A cet effet, l'invention a pour premier objet un procédé d'avivage sous vide par pulvérisation magnétron d'une bande métallique selon la revendication 1.

Le procédé selon l'invention peut en outre incorporer les caractéristiques suivantes, prises isolément ou en combinaison :
- le dispositif de nettoyage est un dispositif de nettoyage à action mécanique localisée.
- le dispositif de nettoyage est constitué d'une racle rigide en contact avec la surface mobile de la contre-électrode.
- les matières décollées de la surface mobile de la contre-électrode par l'action du dispositif de nettoyage sont récupérées à l'aide d'un dispositif de collecte placé en partie basse de ladite enceinte sous vide.
- la contre-électrode est polarisée positivement par rapport à la bande métallique, la bande métallique pouvant être reliée ou non à la masse.
- la contre-électrode est soumise à un potentiel alternatif, la bande métallique pouvant être reliée ou non à la masse.
- l'enceinte sous vide est munie d'une contre-électrode constituée d'au moins deux cylindres rotatifs et d'une courroie tendue sur les cylindres.
- on refroidit la ou les contre-électrodes.

Un second objet de l'invention est constitué par une installation d'avivage par pulvérisation magnétron selon la revendication 10.

L'installation selon l'invention peut en outre incorporer les caractéristiques suivantes, prises isolément ou en combinaison :
- le dispositif de nettoyage est un dispositif de nettoyage à action mécanique localisée,
- le dispositif de nettoyage est constitué d'une racle rigide en contact avec la surface mobile de la contre-électrode,
- l'enceinte sous vide comprend en outre un dispositif de collecte des matières décollées de la surface mobile de la contre-électrode par l'action du dispositif de nettoyage, le dispositif de collecte étant placé en partie basse de ladite enceinte sous vide,
- la contre-électrode est polarisée positivement par rapport à la bande métallique, ladite bande métallique pouvant être reliée ou non à la masse,
- la contre-électrode est soumise à un potentiel alternatif, la bande métallique pouvant être reliée ou non à la masse,
- l'enceinte sous vide est munie d'une contre-électrode constituée d'au moins deux cylindres rotatifs et d'une courroie tendue sur les cylindres,
- la contre-électrode est munie de moyens de refroidissement.

L'invention va à présent être décrite plus en détail en référence aux figures annexées qui représentent :
- figure 1 : vue schématique en coupe d'un mode de réalisation d'une installation selon l'invention,
- figure 2 : vue schématique en coupe d'un second mode de réalisation d'une installation selon l'invention,

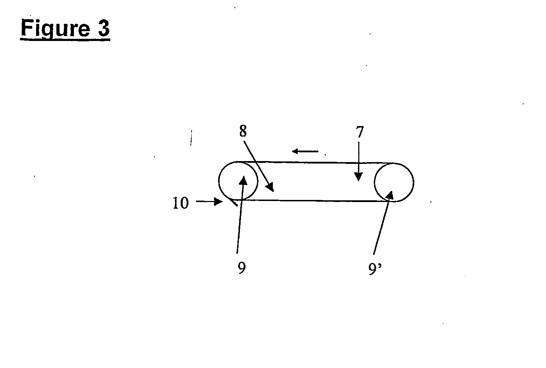

- figure 3 : vue schématique en coupe d'un troisième mode de réalisation d'une installation selon l'invention.

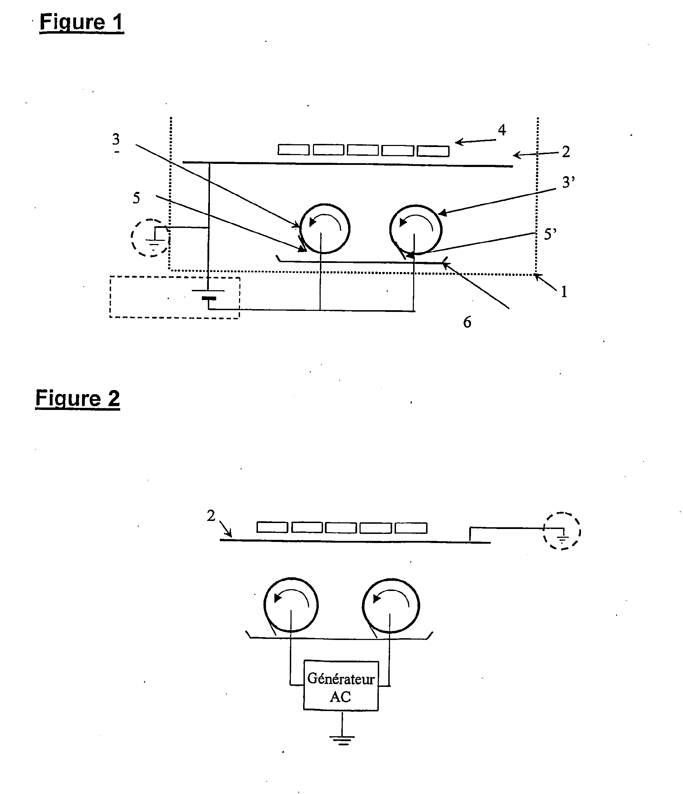

Si l'on considère tout d'abord la figure 1, on peut y voir une enceinte sous vide 1 à l'intérieur de laquelle une bande métallique 2, telle qu'une bande en acier défile. Dans la partie basse de cette enceinte sous vide 1, se trouvent deux contre-électrodes 3 et 3' de forme cylindrique qui peuvent être mise en rotation autour de leurs axes. Les contre-électrodes 3, 3' doivent être en matériau conducteur. Bien qu'un matériau ferromagnétique puisse convenir, il est conseillé d'utiliser un matériau non ferromagnétique afin de ne pas perturber le confinement magnétique du plasma.

Les contre-électrodes 3, 3' sont soumises à un échauffement qui implique de les refroidir dans certains cas. Elles sont entraînées en rotation, par exemple de façon mécanique par le défilement de la bande métallique 2. Les contre-électrodes 3, 3' peuvent également être entraînées par un moteur électrique placé sous vide, un moteur pneumatique, un moteur hydraulique ou par un passage tournant sous vide.

La bande métallique 2 est reliée à la masse tandis que les contre-électrodes 3, 3' sont polarisées positivement.

Au-dessus de cette bande 2, se trouve un circuit magnétique 4 prenant la forme d'aimants qui servent à confiner le plasma à proximité de la bande métallique 2.

Chaque contre-électrode 3, 3' est munie d'une racle 5, 5' placées dans l'ombre du plasma d'avivage de la bande métallique 2. La réalisation de la fixation des racles 5, 5' doit être particulièrement soignée pour éviter de créer un court-circuit entre les contre-électrodes 3, 3' et les autres pièces du montage, ceci même après métallisation des surfaces internes de la cellule par les particules conductrices décapées. Des chicanes anti-métallisation peuvent être disposées autour des isolateurs. Ces chicanes se situent entre la paroi de l'enceinte 1 et les racles 5, 5' afin des les isoler mutuellement. Le support des racles 5, 5' ne sont ainsi pas métallisés, ce qui évite tout court-circuit.

Les racles 5, 5' peuvent être réalisées en tout matériau adapté à condition qu'il ne soit pas conducteur. On pourra notamment les réaliser en céramique ou en verre.

Des précautions peuvent en outre être prises pour que les racles 5, 5' ne projettent pas de copeaux vers la bande métallique 2, même après rebond.

L'enceinte sous vide 1 comprend également un bac 6 de récupération des matières décollées par les racles 5, 5'.

Lorsque la bande métallique 2 est avivée dans l'enceinte sous vide 1, on fait tourner les contre-électrodes 3, 3' dans un mouvement relativement lent, de sorte qu'elles sont continuellement nettoyées au moyen des racles 5, 5'. Les matières décollées par ces moyens tombent dans le bac 6 qui peut être régulièrement vidé.

Si l'on considère à présent la figure 2, on peut y voir un second mode de réalisation de l'invention, dans lequel on applique aux contre-électrodes 3, 3' un potentiel alternatif, la bande métallique 2 en défilement étant ou non reliée à la masse.

Le système peut être constitué d'une ou plusieurs contre-électrodes. Comme on peut le voir sur la vue partielle de la figure 4, la contre-électrode 7 peut également être constituée d'une courroie 8 tendue entre deux cylindres 9, 9' et entraînée suivant le principe du « tapis roulant ». Une racle 10 placée dans l'ombre du plasma permet de nettoyer la courroie lorsqu'elle défile dans l'enceinte sous vide 1.

### Exemple de réalisation

Un indicateur de l'efficacité d'un système d'avivage peut être la puissance maximum que l'on peut appliquer à la cellule d'avivage sans formation d'arcs.

On a donc procédé à un essai dans lequel on a mesuré cette puissance maximum pour une cellule d'avivage classique et pour une cellule d'avivage telle que représentée à la figure 1.

On a ainsi pu mesurer que la puissance maximum stable dans le temps, d'une installation d'avivage selon l'invention représente plus du double de celle d'une installation classique présentant une contre-électrode plane et fixe.

La vitesse d'érosion par avivage magnétron d'une bande métallique étant liée à la puissance appliquée, l'utilisation des contre-électrodes selon l'invention permet de doubler l'efficacité de l'avivage.

Le système de contre-électrodes présenté ci-dessus reste propre au court du temps et évite l'apparition d'arcs à partir de particules issues de l'avivage de la surface de la bande métallique ou le problème d'anode disparaissante.

## Revendications

1. Procédé d'avivage sous vide par pulvérisation magnétron d'une bande métallique (2) défilant au-dessus d'au moins une contre-électrode (3, 3', 7) en matériau conducteur dans une enceinte sous vide (1), dans lequel on crée un plasma dans un gaz à proximité de ladite bande métallique (2), de manière à générer des radicaux et/ou des ions agissant sur cette bande métallique (2), un circuit magnétique de confinement (4) étant placé au-dessus de ladite bande métallique (2), **caractérisé en ce que** ladite contre-électrode (3, 3', 7) présente une surface mobile, en rotation et/ou en translation; par rapport à ladite bande métallique (2), ladite surface étant mise en mouvement lors de l'avivage et étant nettoyée en continu par un dispositif de nettoyage (5, 5', 10) placé dans l'ombre dudit plasma avant d'être à nouveau exposée audit plasma.

2. Procédé d'avivage selon la revendication 1, dans lequel ledit dispositif de nettoyage (5, 5', 10) est un dispositif de nettoyage à action mécanique localisée.

3. Procédé d'avivage selon la revendication 2, dans lequel ledit dispositif de nettoyage (5, 5', 10) est constitué d'une racle rigide en contact avec la surface mobile de ladite contre-électrode (3, 3', 7).

4. Procédé d'avivage selon l'une quelconque des revendications 1 à 3, dans lequel les matières décollées de la surface mobile de ladite contre-électrode (3, 3', 7) par l'action dudit dispositif de nettoyage (5, 5', 10) sont récupérées à l'aide d'un dispositif de collecte (6) placé en partie basse de ladite enceinte sous vide (1).

5. Procédé d'avivage selon l'une quelconque des revendications 1 à 4, dans lequel ladite contre-électrode (3, 3', 7) est polarisée positivement par rapport à la bande métallique (2), ladite bande métallique (2) pouvant être reliée ou non à la masse.

6. Procédé d'avivage selon l'une quelconque des revendications 1 à 4, dans lequel ladite contre-électrode (3, 3', 7) est soumise à un potentiel alternatif, la bande métallique (2) pouvant être reliée ou non à la masse.

7. Procédé selon l'une quelconque des revendications 1 à 6, dans lequel l'enceinte sous vide (1) est munie d'une contre-électrode (7) constituée d'au moins deux cylindres rotatifs (9, 9') et d'une courroie (8) tendue sur lesdits cylindres (9, 9').

8. Procédé selon l'une quelconque des revendications 1 à 7, dans lequel on refroidit ladite contre-électrode (3, 3', 7).

9. Procédé selon l'une quelconque des revendications 1 à 8, dans lequel ladite bande métallique (2) est une bande d'acier.

10. Installation d'avivage sous vide par pulvérisation magnétron d'une bande métallique (2) comprenant une enceinte sous vide (1) avec à l'intérieur au moins une contre-électrode (3, 3', 7), des moyens de polarisation de ladite bande métallique (2), des moyens de polarisation de ladite contre-électrode (3, 3', 7), des moyens permettant de créer un plasma dans un gaz entre ladite bande métallique (2) et ladite contre-électrode (3, 3', 7), au moins un circuit magnétique de confinement (4) étant placé au-dessus de ladite bande métallique (2) l'installation comprenant également des moyens configurés pour faire défiler ladite bande métallique au dessus de ladite contre-électrode (3,3',7); **caracterisée en ce que** ladite contre-électrode (3, 3', 7) présente une surface mobile en rotation et/ou en translation par rapport à ladite bande métallique (2), ainsi qu'un dispositif de nettoyage (5, 5', 10) de ladite surface mobile, placé dans l'ombre dudit plasma.

11. Installation d'avivage selon la revendication 10, dans laquelle ledit dispositif de nettoyage (5, 5', 10) est un dispositif de nettoyage à action mécanique localisée.

12. Installation d'avivage selon la revendication 11, dans laquelle ledit dispositif de nettoyage (5, 5', 10) est constitué d'une racle rigide en contact avec la surface mobile de ladite contre-électrode (3, 3', 7).

13. Installation d'avivage selon l'une quelconque des revendications 10 à 12, dans laquelle l'enceinte sous vide (1) comprend en outre un dispositif de collecte (6) des matières décollées de la surface mobile de ladite contre-électrode (3, 3', 7) par l'action dudit dispositif de nettoyage (5, 5', 10), ledit dispositif de collecte (6) étant placé en partie basse de ladite enceinte sous vide (1).

14. Installation d'avivage selon l'une quelconque des revendications 10 à 13, dans laquelle ladite contre-électrode (3, 3', 7) est polarisée positivement par rapport à la bande métallique (2), ladite bande métallique (2) pouvant être reliée ou non à la masse.

15. Installation d'avivage selon l'une quelconque des revendications 10 à 13, dans laquelle ladite contre-électrode (3, 3', 7) est soumise à un potentiel alternatif, la bande métallique (2) pouvant être reliée ou non à la masse.

16. Installation selon l'une quelconque des revendications 10 à 15, dans laquelle l'enceinte sous vide (1) est munie d'une contre-électrode (7) constitué d'au moins deux cylindres rotatifs (9, 9') et d'une courroie (8) tendue sur lesdits cylindres (9, 9').

17. Installation selon l'une quelconque des revendications 10 à 16, dans laquelle ladite contre-électrode (3, 3', 7) est munie de moyens de refroidissement.

## Claims

1. Vacuum process for etching a metal strip (2) running above at least one counterelectrode (3, 3', 7) made of conductive material by magnetron sputtering in a vacuum chamber (1), in which a plasma is created in a gas close to said metal strip (2) so as to generate radicals and/or ions that act on this mental strip (2), a magnetic confinement circuit (4) being placed above said metal strip (2), **characterized in that** said counterelectrode (3, 3', 7) has a surface that can move, by rotation and/or by translation, relative to said metal strip (2), said surface being set in motion during the etching and being continuously cleaned by a cleaning device (5, 5', 10) placed in the shadow of said plasma before again being exposed to said plasma.

2. Etching process according to Claim 1, in which said cleaning device (5, 5', 10) is a cleaning device having a localized mechanical action.

3. Etching process according to Claim 2, in which said cleaning device (5, 5', 10) consists of a rigid scraper in contact with the moving surface of said counterelectrode (3, 3', 7).

4. Etching process according to any one of Claims 1 to 3, in which the matter scraped off the moving surface of said counterelectrode (3, 3', 7) by the action of said cleaning device (5, 5', 10) is recovered by a collecting device (6) placed on the bottom of said vacuum chamber (1).

5. Etching process according to any one of Claims 1 to 4, in which said counterelectrode (3, 3', 7) is positively biased relative to the metal strip (2), it being possible for said metal strip (2) to be grounded or not.

6. Etching process according to any one of Claims 1 to 4, in which said countereleotrode (3, 3', 7) is subjected to an AC potential, it being possible for the metal strip (2) to be grounded or not.

7. The process according to any one of Claims 1 to 6, in which the vacuum chamber (1) is provided with a counterelectrode (7) consisting of at least two rotating rolls (9, 9') and a tensioned belt (8) on said rolls (9, 9').

8. The process according to any one of Claims 1 to 7, in which said counterelectrode (3, 3', 7) is cooled.

9. Process according to any one of Claims 1 to 8, in which said metal strip (2) is a steel strip.

10. Vacuum installation for etching a metal strip (2) by magnetron sputtering, comprising a vacuum chamber (1) with at least one counterelectrode (3, 3', 7) therein, means for biasing said metal strip (2), means for biasing said counterelectrode (3, 3', 7), means for creating a plasma in a gas between said metal strip (2) and said counterelectrode (3, 3', 7), at least one magnetic confinement circuit (4) being placed above said metal strip (2), the installation also comprising means configured for making said metal strip run above said counterelectrode (3, 3', 7), **characterized in that** said counterelectrode (3, 3', 7) has a surface that can move, by rotation and/or by translation, relative to said metal strip (2), and a cleaning device (5, 5', 10) for cleaning said moving surface, which is placed in the shadow of said plasma.

11. Etching installation according to Claim 10, in which said cleaning device (5, 5', 10) is a cleaning device having a localized mechanical action.

12. Etching installation according to Claim 11, in which said cleaning device (5, 5', 10) consists of a rigid scraper in contact with the moving surface of said counterelectrode (3, 3', 7).

13. Etching installation according to any one of Claims 10 to 12, in which the vacuum chamber (1) further includes a collecting device (6) for collecting the matter scraped off the moving surface of said counterelectrode (3, 3', 7) via the action of said cleaning device (5, 5', 10), said collecting device (6) being placed on the bottom of said vacuum chamber (1).

14. Etching installation according to any one of Claims 10 to 13, in which said counterelectrode (3, 3', 7) is positively biased relative to the metal strip (2), it being possible for said metal strip (2) to be grounded or not.

15. Etching installation according to any one of Claims 10 to 13, in which said counterelectrode (3, 3', 7) is subjected to an AC potential, it being possible for the metal strip (2) to be grounded or not.

16. Installation according to any one of Claims 10 to 15, in which the vacuum chamber (1) is provided with a counterelectrode (7) consisting of at least two rotating rolls (9, 9') and a tensioned belt (8) on said rolls (9, 9').

17. Installation according to any one of Claims 10 to 16, in which said counterelectrode (3, 3', 7) is provided with cooling means.

## Patentansprüche

1. Verfahren zur Unterdruck-Avivage durch Magnetronzerstäubung eines Metallbandes (2), das sich über wenigstens einer Gegenelektrode (3, 3', 7) aus leitendem Material in einem Unterdruckbehälter (1) vorbei bewegt, wobei in einem Gas in der Umgebung des Metallbandes (2) ein Plasma erzeugt wird, derart, dass Radikale und/oder Tonen erzeugt werden, die auf dieses Metallband (2) einwirken, wobei ein Einschluss-Magnetkreis (4) über dem Metallband (2) angeordnet ist, **dadurch gekennzeichnet, dass** die Gegenelektrode (3, 3', 7) eine in Bezug auf das Metallband (2) rotatorisch und/oder translatorisch bewegliche Oberfläche aufweist, wobei die Oberfläche bei der Avivage in Bewegung versetzt wird und durch eine Reinigungsvorrichtung (5, 5', 10), die im Schatten des Plasmas angeordnet ist, ununterbrochen gereinigt wird, bevor sie erneut dem Plasma ausgesetzt wird.

2. Avivageverfahren nach Anspruch 1, wobei die Reinigungsvorrichtung (5, 5', 10) eine Reinigungsvorrichtung mit räumlich begrenzter mechanischer Wirkung ist.

3. Avivageverfahren nach Anspruch 2, wobei die Reinigungsvorrichtung (5, 5', 10) aus einer starren Abstreicheinrichtung gebildet ist, die mit der beweglichen Oberfläche der Gegenelektrode (3, 3', 7) in Kontakt ist.

4. Avivageverfahren nach einem der Ansprüche 1 bis 3, wobei das von der beweglichen Oberfläche der Gegenelektrode (3, 3', 7) durch die Wirkung der Reinigungsvorrichtung (5, 5', 10) abgelösten Stoffe mit Hilfe einer Sammelvorrichtung (6), die im unteren Teil des Unterdrackbehälters (1) angeordnet ist, wiedergewonnen werden.

5. Avivageverfahren nach einem der Ansprüche 1 bis 4, wobei die Gegenelektrode (3, 3', 7) in Bezug auf das Metallband (2) positiv vorgespannt ist, wobei das Metallband (2) mit Masse verbunden sein kann oder nicht.

6. Avivageverfahren nach einem der Ansprüche 1 bis 4, wobei die Gegenelektrode (3, 3', 7) einem Wechselspannungspotential unterworfen wird, wobei das Metallband (2) mit Masse verbunden sein kann oder nicht.

7. Verfahren nach einem der Ansprüche 1 bis 6, wobei der Unterdruckbehälter (1) mit einer Gegenelektrode (7) versehen ist, die aus wenigstens zwei rotierenden Zylindern (9, 9') und einem um die Zylinder (9, 9') gespannten Riemen (8) gebildet ist.

8. Verfahren nach einem der Ansprüche 1 bis 7, wobei die Gegenelektrode (3, 3', 7) gekühlt wird.

9. Verfahren nach einem der Ansprüche 1 bis 8, wobei das Metallband (2) ein Stahlband ist.

10. Anlage zur Unterdruck-Avivage durch Magnetronzerstäubung eines Metallbandes (2), die einen Unterdruckbehälter (1), in dessen Innenraum wenigstens eine Gegenelektrode (3, 3', 7) vorhanden ist, Mittel zum Vorspannen des Metallbandes (2), Mittel zum Vorspannen der Gegenelektrode (3, 3', 7), Mittel, die ermöglichen, in einem Gas zwischen dem Metallband (2) und der Gegenelektrode (3, 3', 7) ein Plasma zu erzeugen, und wenigstens einen Einschluss-Magnetkreis (4), der über dem Metallband (2) angeordnet ist, umfasst, wobei die Anlage außerdem Mittel umfasst, die konfiguriert sind, um das Metallband zu einer Vorbeibewegung über der Gegenelektrode (3, 3', 7) zu veranlassen, **dadurch gekennzeichnet, dass** die Gegenelektrode (3, 3', 7) eine rotatorisch und/oder translatorisch in Bezug auf das Metallband (2) bewegliche Oberfläche sowie eine Reinigungsvorrichtung (5, 5', 10) für die bewegliche Oberfläche, die im Schatten des Plasmas angeordnet ist, aufweist.

11. Avivageanlage nach Anspruch 10, wobei die Reinigungsvorrichtung (5, 5', 10) eine Reinigungsvorrichtung mit räumlich begrenzter mechanischer Wirkung ist.

12. Avivageanlage nach Anspruch 11, wobei die Reinigungsvorrichtung (5, 5', 10) eine starre Abstreicheinrichtung ist, die mit der beweglichen Oberfläche der Gegenelektrode (3, 3', 7) in Kontakt ist.

13. Avivageanlage nach einem der Ansprüche 10 bis 12, wobei der Unterdruckbehälter (1) außerdem eine Sammelvorrichtung (6) für von der beweglichen Oberfläche der Gegenelektrode (3, 3', 7) durch die Wirkung der Reinigungsvorrichtung (5, 5', 10) abgelöste Stoffe umfasst, wobei die Sammelvorrichtung (6) im unteren Teil des Behälters (1) unter Vakuum angeordnet ist.

14. Avivageanlage nach einem der Ansprüche 10 bis 13, wobei die Gegenelektrode (3, 3', 7) in Bezug auf das Metallband (2) positiv vorgespannt ist, wobei das Metallband (2) mit Masse verbunden sein kann oder nicht.

15. Avivageanlage nach einem der Ansprüche 10 bis 13, wobei die Gegenelektrode (3, 3', 7) einem Wechselspannungspotential unterworfen wird, wobei das Metallband (2) mit Masse verbunden sein kann oder nicht.

16. Anlage nach einem der Ansprüche 10 bis 15, wobei der Behälter (1) unter Vakuum mit einer Gegenelektrode (7) versehen ist, die aus wenigstens zwei rotierenden Zylindern (9, 9') und einem um diese Zylinder (9, 9') gespannten Riemen (8) gebildet ist.

17. Anlage nach einem der Ansprüche 10 bis 16, wobei die Gegenelektrode (3, 3', 7) mit Kühlungsmitteln versehen ist.
